# EUROPÄISCHE PATENTSCHRIFT

(11) **EP 3 647 943 B1**
(45) Veröffentlichungstag und Bekanntmachung des Hinweises auf die Patenterteilung: **24.01.2024**
(21) Anmeldenummer: 18203385.2
(22) Anmeldetag: 30.10.2018
(51) Int. Cl.: G06F 8/65, G06N 20/00, G06N 3/08

(54) **VERFAHREN ZUM BESTIMMEN MINDESTENS EINES KENNZEICHENS MINDESTENS EINER ÄNDERUNG**
METHOD FOR DETERMINING AT LEAST ONE CHARACTERISTIC OF AT LEAST A CHANGE
PROCÉDÉ DE DÉTERMINATION D'AU MOINS UN INDICATEUR D'AU MOINS UN CHANGEMENT

(43) Veröffentlichungstag der Anmeldung: 06.05.2020
(73) Patentinhaber: Siemens Aktiengesellschaft, 80333 München (DE)
(72) Erfinder: Kempter, Bernhard, 80339 München (DE); Montrone, Francesco, 85521 Riemerling (DE); Wieghardt, Jan, 81475 München (DE); Zeller, Marc, 81243 München (DE)
(74) Vertreter: Siemens Patent Attorneys

(56) Entgegenhaltungen:
- US-A1- 2009 271 346
- US-A1- 2017 357 716

## Beschreibung

### 1. Technisches Gebiet

Die Erfindung betrifft ein computer-implementiertes Verfahren zum Bestimmen mindestens eines Kennzeichens mindestens einer Änderung. Ferner ist die Erfindung auf eine entsprechende Bestimmungseinheit und Computerprogrammprodukt gerichtet.

### 2. Stand der Technik

Ansätze zur Änderung von Software in Vorrichtungen, Anlagen oder sonstigen Systemen sind bereits aus dem Stand der Technik bekannt. Bei programmgesteuerten Vorrichtungen bzw. Vorrichtungen mit Software-Applikationen besteht zunehmend das Problem, dass die Software einmalig oder mehrmalig geändert werden soll oder muss. Die Änderung der betreffenden Software kann aus unterschiedlichen Gründen erforderlich sein, beispielsweise da sie fehlerhaft ist oder eine Aktualisierung benötigt.

Beispielsweise kann es sich bei der Vorrichtung oder der Anlage um eine autonome Einheit, wie ein autonomes Fahrzeug, handeln. Das Fahrzeug kann als Zug oder Auto etc. ausgebildet sein. Auf der autonomen Einheit ist die Software installiert. Bei autonomen Fahrzeugen ist es erforderlich, dass die Software bzw. der zugehörige Quellcode, welcher beispielsweise für die Funktionalität der Steuerung des Fahrzeugs vorgesehen ist, fehlerfrei und reibungslos funktioniert. Das autonome Fahrzeug kann durch die Steuerungssoftware beispielsweise Hindernisse, wie Personen auf der Fahrbahn oder den Schienen erkennen sowie die richtigen Maßnahmen nach der Erkennung einleiten. Beispielsweise verringert das autonome Fahrzeug die Geschwindigkeit oder kommt zum Stillstand sobald sich dem Fahrzeug Personen annähern.

Gerade bei autonomen Einheiten betreffen die meisten Software-Änderungen sicherheitskritische oder sicherheitsrelevante Aspekte oder Funktionen der Fahrzeugsteuerung, wie die obige Hinderniserkennung. Diese sicherheitsrelevanten Software-Änderungen müssen zunächst vor deren Umsetzung festgestellt werden. Anschließend müssen diese Software-Änderungen umgesetzt werden. Die Feststellung und Umsetzung müssen fehlerfrei erfolgen, um einen Personen- sowie Sachschaden zu verhindern. Im obigen Fehlerfall, bei einer Fehlfunktion der Software, erkennt die Software eine Person auf der Fahrbahn nicht oder verspätet und es kommt zu einem Zusammenstoß der Person mit dem Fahrzeug, bei dem die Person Verletzungen davonträgt.

Üblicherweise wird eine sogenannte Änderungsauswirkungsanalyse ("change impact analysis") durchgeführt, um zu bestimmen, ob die Auswirkung bzw. die Folge einer Änderung eine Auswirkung auf die Sicherheit hat, wie Systemsicherheit. Die Analyse erfolgt gemäß bestimmten Sicherheitsstandards (z.B. IEC 61508) und wird herkömmlich manuell durchgeführt.

Die manuelle Analyse ist mit dem Nachteil verbunden, dass ein erheblicher personeller Einsatz erforderlich ist, welcher zeitaufwendig, fehleranfällig und kostenintensiv ist. Meist muss eine große Anzahl der Änderungen, einige Hunderte, analysiert werden, ob ihre Auswirkungen potentiell die Sicherheit betreffen könnten. Gerade hinsichtlich der obigen autonomen Einheiten steigt die Anzahl sicherheitsrelevanter Änderungen zunehmend und somit das Datenvolumen. Ein weiterer Nachteil besteht darin, dass zwischen dem Zeitpunkt, zu dem die Notwendigkeit einer Software-Änderung erkannt wird und dem Zeitpunkt, zu dem diese Änderung nach der aufwendigen Analyse erfolgt, auch ein erheblicher Zeitraum liegen kann. In diesem Zeitraum kann die Vorrichtung nicht oder nur mit überholter bzw. veralteter Software betrieben werden, beispielsweise ohne Sicherheitsupdate.

Das Dokument US 2009/0271346 A1 offenbart eine Bibliotheksynchronisation zwischen Definitionen und Instanzen. Dabei kann die Definition als allgemeine Definition betrachtet werden, welche mehrere Einheiten verwenden. Diese allgemeine Definition kann sich von einer lokalen Definition unterscheiden. Die lokale Definition kann eine Definition sein, welche nur auf einer Einheit verwendet wird und üblicherweise auf einer allgemeinen Definition einer anderen Einheit basiert. Die Definition kann sich ändern und es kann angebracht sein die zugehörigen Instanzen entsprechend der Änderung zu ändern. Unterschiedliche Standards können eingesetzt werden, um zu bestimmen, ob die Änderung einer Instanz automatisch propagiert werden soll oder zu einem anderen Zeitpunkt. Die Bestimmung kann Artificial intelligence- Verfahren verwenden.

Das Dokument US 2017/0357716 A1 betrifft ein Verfahren zum Betreiben eines digitalen Assistenten, umfassend: Empfangen von unstrukturierten Informationen in natürlicher Sprache von mindestens einem Benutzer; Bestimmen, ob Ereignisinformationen in den unstrukturierten Informationen in natürlicher Sprache vorhanden sind; und Bestimmen eines Ereignistyps des Ereignisses und das Bereitstellen einer Ereignisbeschreibung basierend auf dem Ereignistyp.

Die vorliegende Erfindung stellt sich daher die objektive technische Aufgabe ein Verfahren zum Bestimmen mindestens eines Kennzeichens mindestens einer Änderung bereitzustellen, welches effizient und zuverlässig ist.

### 3. Zusammenfassung der Erfindung

Die oben genannte Aufgabe wird erfindungsgemäß durch ein Verfahren zum Bestimmen mindestens eines Kennzeichens mindestens einer Softwareänderung gemäß den Schritten des unabhängigen Anspruchs 1 gelöst.

Dementsprechend ist die Erfindung auf ein Verfahren zum Bestimmen eines Kennzeichens einer Änderung gerichtet. Das Kennzeichen ist ein Tag oder Hinweis auf das Vorliegen eines bestimmten Kennzeichens der Änderung. Das Kennzeichen kann auch als Eigenschaft betrachtet werden. Hinsichtlich der Änderungsauswirkungsanalyse ("change impact analysis") gibt das Kennzeichen an, ob die Änderung eine Auswirkung auf die Sicherheit hat, insbesondere die betriebliche Sicherheit oder auch die Systemsicherheit. Mit anderen Worten wird durch das erfindungsgemäße Verfahren festgestellt, ob die Änderung sicherheitsrelevant ist bevor die Änderung umgesetzt wird. Die Änderung kann eine Erweiterung, eine Einschränkung oder sonstige Änderung einer Softwareapplikation sein. Beispielsweise kann es sich bei der Änderung einer Softwareapplikation um eine Änderung einer Variablen oder eines Algorithmus im Quellcode der Software handeln.

In einem ersten Schritt wird der Eingabedatensatz empfangen.

Der Eingabedatensatz kann über eine oder mehrere Schnittstellen durch die unten stehende Bestimmungseinheit empfangen werden, wie autonome Einheit, sonstige Softwareeinheit oder Recheneinheit. Ferner weist der Eingabedatensatz die Änderung sowie weitere mit dieser in Beziehung stehende Daten, wie den zugehörigen Quellcode mit oder ohne der Änderung etc. auf, siehe weiter unten.

In einem zweiten Schritt wird das Kennzeichen der Änderung bestimmt. Hierzu wird ein lernbasierter Ansatz auf den empfangenen Eingabedatensatz angewendet. Beispielsweise wird ein neuronales Netzwerk als Ansatz für das maschinelle Lernen verwendet. Üblicherweise wird zunächst das neuronale Netzwerk mit gekennzeichneten Trainingsdatensätzen trainiert. Mit anderen Worten weist ein Trainingsdatensatz zusätzlich zu der Änderung bereits das Kennzeichen auf. Nach dieser Trainingsphase wird das trainierte neuronale Netzwerk für den empfangenen Eingabedatensatz verwendet, um für eine neue oder nicht umgesetzte Änderung eines Eingabedatensatzes das Kennzeichen zu bestimmen.

Der Vorteil liegt darin, dass die Bestimmung des Kennzeichens der Änderung im Gegensatz zum Stand der Technik selbständig oder eigenständig durch die Bestimmungseinheit effizient durchgeführt wird. Dadurch kann Personal sowie Zeit eingespart werden. Weiterhin ist die Bestimmungseinheit vorteilhafterweise weniger fehleranfällig und somit zuverlässiger. Dadurch können die Ausfallzeiten bzw. Stillstände des zugrundeliegenden Systems oder der Anlage, an welchem/an welcher die Änderung durchgeführt werden muss, reduziert oder sogar vermieden werden. Folglich können die Kosten erheblich reduziert werden.

In einer Ausgestaltung ist die Änderung eine Erweiterung, eine Einschränkung oder eine sonstige Änderung einer Software. Dementsprechend ist die Änderung eine Softwareänderung. Beispielhafte Softwareänderungen sind Änderungen im Quellcode, wie Änderung einer Variablen, eines Algorithmus, einzelner Schritte des Algorithmus, eines Datentyps, eines Namens etc. Dabei sind Änderungen des Algorithmus üblicherweise sicherheitsrelevanter als Namensänderungen. Die erstgenannte Änderung hat eher eine Wirkung nach außen als Änderungen, welche lediglich die Nomenklatur betreffen. Diese Kriterien können als Filterkriterien im Filterschritt berücksichtigt werden, wie weiter unten im Detail erläutert.

In einer weiteren Ausgestaltung ist der Eingabedatensatz in einer Speichereinheit gespeichert, insbesondere in Form eines Merkmalsvektors. Dementsprechend können beispielsweise die Änderung, beispielsweise im Quellcode und das Kennzeichen als Merkmale, Attribute oder Eigenschaften betrachtet werden. Die Mehrzahl der Merkmale kann auch als Merkmalsvektor oder Reihe (auch "Array") von Merkmalen zusammengefasst. Die Merkmale können in einer Exceltabelle, einer Datenbank, einer Cloud oder einer sonstigen Speichereinheit abgelegt werden. Die Datenspeicherung hat sich hinsichtlich eines effizienten und zuverlässigen Zugriffs auf die Daten als besonders vorteilhaft erwiesen.

In einer weiteren Ausgestaltung weisen die assoziierten Daten eine Beschreibung der mindestens einen Änderung und/oder der weiteren Hintergründe zu der mindestens einen Änderung auf, insbesondere in natürlicher Sprache. Dementsprechend können zusätzlich zur Änderung weitere assoziierte Daten in der Speichereinheit gespeichert werden. Die assoziierten Daten sind beispielsweise Auszüge des betroffenen Quellcodes bei Software-Änderungen, die betroffenen Hardware-Einheiten bei Hardware-Änderungen und die Beschreibung. Der Quellcode ist maschinenlesbar ausgestaltet. Die zusätzliche Beschreibung kann dagegen durch einen Experten dokumentiert werden und bleibt für Personen lesbar. Die Hintergründe können den Grund für die Änderung und die erwartete oder vorhergesehene Auswirkung aufweisen. Dadurch umfassen die assoziierten Daten vorteilhafterweise sowohl maschinen-lesbare Daten als auch für Personen lesbare Daten. Ferner können die assoziierten Daten vorteilhafterweise automatisch erstellt und/oder durch Experten manuell erstellt oder ergänzt werden. Die assoziierten Daten sind effizient und flexibel um Informationen erweiterbar.

In einer weiteren Ausgestaltung ist der lernbasierte Ansatz ausgewählt aus der Gruppe bestehend aus einem neuronalen Netzwerk, bestärkendes Lernen ("Reinforcement Learning") oder einem sonstigen Algorithmus des maschinellen Lernens. Dementsprechend können jegliche Algorithmen des maschinellen Lernens flexibel abhängig von Anforderungen oder Nutzerpräferenzen ausgewählt werden. Das neuronale Netzwerk hat sich hinsichtlich eines großen Datenvolumens ("big data") und folglich zum Trainieren mit einer großen Anzahl von Eingabedatensätzen als besonders vorteilhaft erwiesen. Die Zuverlässigkeit des neuronalen Netzwerks verbessert sich durch kontinuierliches Lernen.

In einer weiteren Ausgestaltung ist das neuronale Netzwerk ein trainiertes neuronales Netzwerk. Dementsprechend wird das erfindungsgemäße Verfahren auf Basis des trainierten neuronalen Netzwerks durchgeführt. Mit anderen Worten erfolgt die Änderungsauswirkungsanalyse auf dem trainierten Neuronalen Netzwerk.

In einer weiteren Ausgestaltung weist das Verfahren weiterhin den Zwischenschritt nach Schritt a. auf, Filtern des Eingabedatensatzes zumindest zum Teil anhand mindestens eines Filterkriteriums. Dementsprechend geht dem zweiten Verfahrensschritt b. eine Filterung voraus. Beispielsweise kann nach Relevanz bzw. Priorität hinsichtlich des Kennzeichens gefiltert werden. Die obigen Namensänderungen, welche lediglich die Nomenklatur betreffen, haben eine geringe bis keine Relevanz und werden in Schritt b. nicht betrachtet. Ferner können die Eingabedatensätze mit den Änderungen zwischen zwei Softwareupdates festgestellt werden und nur das Delta weiterhin für Schritt b. betrachtet werden. Dadurch kann Zeit eingespart werden.

In einer weiteren Ausgestaltung weist das Verfahren weiterhin das Bestimmen eines Ergebniswerts für das mindestens eine Kennzeichen der mindestens einen Änderung auf, wobei der Ergebniswert insbesondere ein Wahrscheinlichkeitswert ist. Dementsprechend kann anhand des Ergebniswerts sowie dessen Überschreitung eines Schwellwerts die Wahrscheinlichkeit für das Vorliegen der Eigenschaft festgestellt werden. Der Schwellwert kann auch als Grenzwert bezeichnet werden und die Feststellung als Detektion oder Erkennung. Insbesondere kann der Schwellwert flexibel an Anforderungen oder andere Bedingungen angepasst werden. Der Ähnlichkeitstest hat sich hinsichtlich der Zuverlässigkeit des Verfahrens als besonders vorteilhaft erwiesen.

Weiterhin weist das Verfahren das
- Freigeben der mindestens einen Änderung anhand des bestimmten Ergebniswerts; wobei
- eine Freigabe vorliegt, falls der Ergebniswert einen vorbestimmten Schwellwert überschreitet;
- Umsetzen der mindestens einen Änderung bei Freigabe;
auf.

In einer weiteren Ausgestaltung ist die sonstige Maßnahme ein Verfahrensschritt ist, ausgewählt aus der Gruppe bestehend aus
- Ausgeben und/oder Übertragen einer Nachricht an eine Einheit; wobei die Nachricht das mindestens eine Kennzeichen, den Ergebniswert, die mindestens eine Änderung, die assoziierten Daten, sonstige Daten der Eingabe- und/oder Ausgabedaten umfasst;
- Umsetzen mindestens einer weiteren Änderung, wobei die weitere Änderung bereits freigegeben ist.

In einer weiteren Ausgestaltung berücksichtigt die Nachricht den Ergebniswert.

Ferner betrifft die Erfindung eine Bestimmungsvorrichtung zum Durchführen des obigen Verfahrens.

Dementsprechend wird das erfindungsgemäße Verfahren durch eine Bestimmungseinheit, wie autonome Einheit, durchgeführt. Zusätzlich zur Bestimmung des Kennzeichens kann die autonome Einheit die Änderung freigeben oder verwerfen auf Basis des Ergebniswerts. Ferner kann die Bestimmungseinheit eine oder mehrere andere Maßnahmen einleiten. Die Bestimmungseinheit kann hierzu einen oder mehrere der Schritte gleichzeitig oder nacheinander durchführen. Ferner kann die Bestimmungseinheit auch stufenweise vorgehen. Sie kann eine Nachricht übermitteln, beispielsweise durch Übertragung einer entsprechenden Nachricht oder Mitteilung über das Kennzeichen sowie seines Ergebniswerts an eine andere Einheit, wie ein Endgerät, eine Steuereinheit oder sonstige Recheneinheit, welche eine entsprechende Maßnahme ergreift. Alternativ oder zusätzlich kann die Bestimmungseinheit auch selbst ohne eine andere Einheit die entsprechende Maßnahme einleiten. Dadurch können die Umsetzung der Änderung sowie jegliche andere Maßnahmen effizient und zuverlässig durchgeführt werden ohne eine weitere Komponente zu benötigen.

Die Erfindung betrifft ferner ein Computerprogrammprodukt mit einem Computerprogramm, das Mittel zur Durchführung des oben beschriebenen Verfahrens, wenn das Computerprogramm auf einer programmgesteuerten Einrichtung zur Ausführung gebracht wird. Ein Computerprogrammprodukt, wie z.B. ein Computerprogramm-Mittel, kann beispielsweise als Speichermedium, wie z.B.

Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen. Als programmgesteuerte Einrichtung kommt insbesondere eine Steuereinrichtung, wie beispielsweise eine Industriesteuerungs-PC oder eine Speicherprogrammierbare Steuerung oder ein Programmable Logic Controller, kurz PLC, oder ein Mikroprozessor für eine Smartcard oder dergleichen in Frage.

### 4. Kurze Beschreibung der Zeichnungen

In der folgenden detaillierten Beschreibung werden vorliegend bevorzugte Ausführungsformen der Erfindung weiter beschrieben mit Bezug auf die folgenden Figuren.
- FIG 1: zeigt ein erfindungsgemäßes Ablaufdiagramm.
- FIG 2: zeigt einen beispielhaften Trainingsdatensatz als Eingabe für den lernbasierten Ansatz oder Ausgabedatensatz mit dem Kennzeichen gemäß einer Ausführungsform der Erfindung.

### 5. Beschreibung der bevorzugten Ausführungsformen

Im Folgenden werden bevorzugte Ausführungsformen der vorliegenden Erfindung in Bezug auf die Figuren beschrieben.

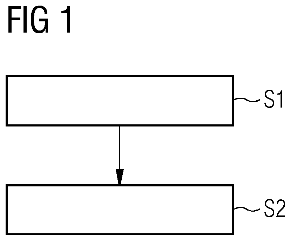

Figur 1 stellt ein Ablaufdiagramm des erfindungsgemäßen Verfahrens mit den Verfahrensschritten S1 und S2 schematisch dar. Die einzelnen Verfahrensschritte können jeweils durch die Bestimmungseinheit oder auch deren Untereinheiten durchgeführt werden.

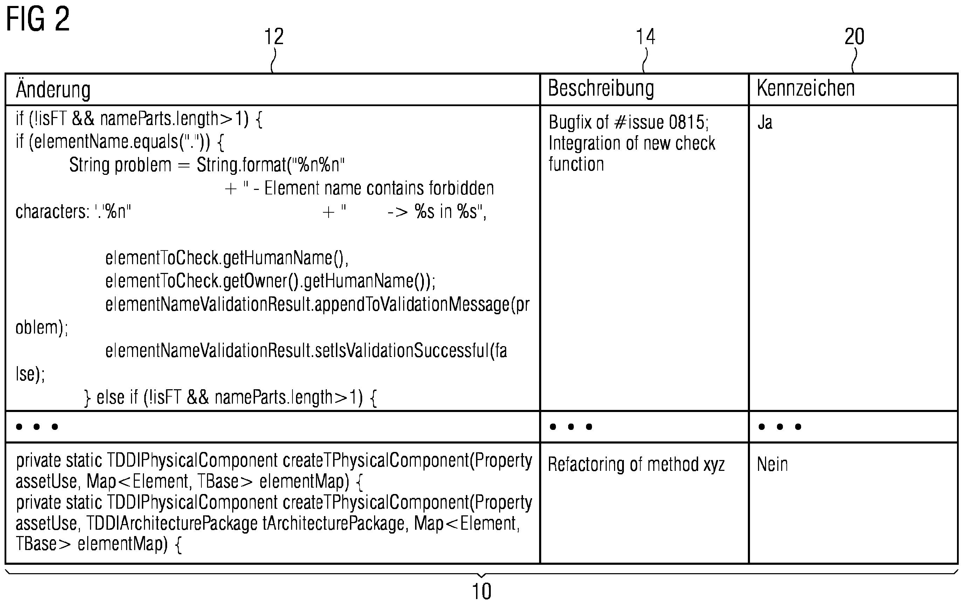

Figur 2 zeigt einen Trainingsdatensatz, welcher als Eingabe für den untrainierten lernbasierten Ansatz, wie neuronales Netzwerk, dient. Der Trainingsdatensatz ist in Form einer Tabelle dargestellt. Jede Zeile umfasst einen Trainingsdatensatz mit der Änderung 12 sowie den assoziierten Daten 14. Der Ausgabendatensatz des erfindungsgemäßen Verfahrens kann ebenfalls in diesem oder einem anderen Format ausgeben werden.

Die dargestellte Änderung 12 ist eine Änderung des Quellcodes. Die dargestellten assoziieren 14 Daten sind die Beschreibung der Änderung, beispielsweise eine generelle Beschreibung der Änderung sowie deren Hintergründe, wie Gründe dafür die Änderung durchzuführen etc., wie weiter oben im Detail beschrieben. Ferner umfassen die Trainingsdatensätze im Gegensatz zu den Eingabedatensätzen 10 bereits die Kennzeichen für die Änderungen 12. Die Kennzeichen können durch Experten erstellt und/oder ergänzt werden. Das Kennzeichen 20 kann einen Hinweis auf die Sicherheitsrelevanz geben, sicherheitsrelevant (Ja, True) oder nicht sicherheitsrelevant (NEIN, False).

Das neuronale Netzwerk wird zunächst mit den existierenden oder bereits vorhandenen sowie gespeicherten Trainingsdatensätzen aus Figur 2 trainiert. Mit anderen Worten wird das neuronale Netzwerk dahingehend trainiert zu unterscheiden, ob die Änderung der Software sicherheitsrelevant ist. Anschließend kann der Eingabedatensatz 10 mit einer neuen Änderung durch das trainierte neuronale Netzwerk analysiert werden. Das erfindungsgemäße Verfahren stellt folglich fest, ob die neue Änderung sicherheitsrelevant ist bevor die Änderung erfolgt.

### Bezugszeichenliste

- 10: Eingabedatensatz
- 12: Änderung
- 14: assoziierte Daten
- 20: Ausgabedatensatz
- S1 bis S2: Verfahrensschritte

## Patentansprüche

1. Verfahren zum Bestimmen mindestens eines Kennzeichens (20) mindestens einer Änderung (12), aufweisend die folgenden seitens einer Bestimmungsvorrichtung auszuführenden Schritte:
a. Empfangen mindestens eines Eingabedatensatzes (10) mit der mindestens einen Änderung (12) und assoziierten Daten (14); wobei
b. die mindestens eine Änderung eine Softwareänderung ist;
c. Bestimmen des mindestens einen Kennzeichens (20) der mindestens einen Änderung (12) durch maschinelles Lernen auf Basis des mindestens einen empfangenen Eingabedatensatz (10); wobei
d. das mindestens eine Kennzeichen angibt, ob die mindestens eine Änderung eine Auswirkung auf die Sicherheit hat und sicherheitsrelevant ist;
e. Bestimmen eines Ergebniswerts für das mindestens eine Kennzeichen (20) der mindestens einen Änderung (12), wobei der Ergebniswert ein Wahrscheinlichkeitswert ist;
f. Freigeben der mindestens einen Änderung (12) anhand des bestimmten Ergebniswerts; wobei
- eine Freigabe vorliegt, falls der Ergebniswert einen vorbestimmten Schwellwert überschreitet;
- Umsetzen der mindestens einen Änderung (12) bei Freigabe.

2. Verfahren nach Anspruch 1, wobei die Änderung (12) eine Erweiterung, eine Einschränkung oder eine sonstige Änderung einer Hardware-Einheit oder einer Software ist.

3. Verfahren nach Anspruch 1 oder Anspruch 2, wobei der Eingabedatensatz (10) in einer Speichereinheit gespeichert ist, insbesondere in Form eines Merkmalsvektors.

4. Verfahren nach einem der vorhergehenden Ansprüche, wobei die assoziierten Daten (14) eine Beschreibung der mindestens einen Änderung (12) und/oder der weiteren Hintergründe zu der mindestens einen Änderung aufweist, insbesondere in natürlicher Sprache.

5. Verfahren nach einem der vorhergehenden Ansprüche, wobei der lernbasierte Ansatz ausgewählt ist aus der Gruppe bestehend aus einem neuronalen Netzwerk, bestärkendes Lernen oder einem sonstigen Algorithmus des maschinellen Lernens.

6. Verfahren nach Anspruch 5, wobei das neuronale Netzwerk ein trainiertes neuronales Netzwerk ist.

7. Verfahren nach einem der vorhergehenden Ansprüche, weiterhin aufweisend den Zwischenschritt nach Schritt a., Filtern des Eingabedatensatzes (10) zumindest zum Teil anhand mindestens eines Filterkriteriums.

8. Verfahren nach Anspruch 7, weiterhin aufweisend Einleiten einer sonstigen Maßnahme bei Freigabe oder bei Verwerfen der mindestens einen Änderung (12).

9. Verfahren nach Anspruch 8, wobei die sonstige Maßnahme ein Verfahrensschritt ist, ausgewählt aus der Gruppe bestehend aus
- Ausgeben und/oder Übertragen einer Nachricht an eine Einheit; wobei die Nachricht das mindestens eine Kennzeichen (20), den Ergebniswert, die mindestens eine Änderung (12), die assoziierten Daten (14), sonstige Daten der Eingabe- und/oder Ausgabedatensätze umfasst;
- Umsetzen mindestens einer weiteren Änderung, wobei die weitere Änderung bereits freigegeben ist.

10. Verfahren nach Anspruch 9, wobei die Nachricht den Ergebniswert berücksichtigt.

11. Bestimmungsvorrichtung zum Durchführen des Verfahrens nach einem der vorhergehenden Ansprüche.

12. Computerprogrammprodukt mit einem Computerprogramm, das Mittel zur Durchführung des Verfahrens nach einem der Ansprüche 1 bis 10 aufweist, wenn das Computerprogramm auf einer programmgesteuerten Einrichtung zur Ausführung gebracht wird.

## Claims

1. Method for determining at least one indication (20) of at least one change (12), having the following steps to be carried out by a determination apparatus:
a. receiving at least one input data record (10) having the at least one change (12) and associated data (14); wherein
b. the at least one change is a software change;
c. determining the at least one indication (20) of the at least one change (12) by means of machine learning on the basis of the at least one received input data record (10); wherein
d. the at least one indication indicates whether the at least one change has an effect on safety and is relevant to safety;
e. determining a result value for the at least one indication (20) of the at least one change (12), wherein the result value is a probability value;
f. approving the at least one change (12) on the basis of the determined result value; wherein
- there is approval if the result value exceeds a predetermined threshold value;
- implementing the at least one change (12) in the case of approval.

2. Method according to Claim 1, wherein the change (12) is an extension, a restriction or another change to a hardware unit or software.

3. Method according to Claim 1 or Claim 2, wherein the input data record (10) is stored in a storage unit, in particular in the form of a feature vector.

4. Method according to one of the preceding claims, wherein the associated data (14) have a description of the at least one change (12) and/or of the further background relating to the at least one change, in particular in a natural language.

5. Method according to one of the preceding claims, wherein the learning-based approach is selected from the group consisting of a neural network, reinforcement learning or another machine learning algorithm.

6. Method according to Claim 5, wherein the neural network is a trained neural network.

7. Method according to one of the preceding claims, also having the intermediate step after step a., filtering the input data record (10) at least partially on the basis of at least one filter criterion.

8. Method according to Claim 7, also comprising initiating another measure in the case of approval or if the at least one change (12) is rejected.

9. Method according to Claim 8, wherein the other measure is a method step selected from the group consisting of
- outputting and/or transmitting a message to a unit; wherein the message comprises the at least one indication (20), the result value, the at least one change (12), the associated data (14), other data from the input and/or output data records;
- implementing at least one further change, wherein the further change has already been approved.

10. Method according to Claim 9, wherein the message takes into account the result value.

11. Determination apparatus for carrying out the method according to one of the preceding claims.

12. Computer program product having a computer program which has means for carrying out the method according to one of Claims 1 to 10 when the computer program is executed on a program-controlled device.

## Revendications

1. Procédé destiné à la détermination d'au moins un indicateur (20) d'au moins une modification (12), présentant les étapes à mettre en oeuvre suivantes du côté d'un dispositif de détermination :
a. la réception d'au moins un ensemble de données d'entrée (10) avec l'au moins une modification (12) et des données associées (14) ; dans lequel
b. l'au moins une modification est une modification de logiciel ;
c. la détermination de l'au moins un indicateur (20) de l'au moins une modification (12) par le biais d'un apprentissage machine sur la base de l'au moins un ensemble de données d'entrée (10) reçu ; dans lequel
d. l'au moins un indicateur indique si l'au moins une modification a une incidence sur la sécurité et est pertinente en termes de sécurité ;
e. la détermination d'une valeur de résultat pour l'au moins un indicateur (20) de l'au moins une modification (12), dans lequel la valeur de résultat est une valeur de probabilité ;
f. la validation de l'au moins une modification (12) à l'aide de la valeur de résultat déterminée ; dans lequel
- une validation se produit dans le cas où la valeur de résultat est supérieure à une valeur de seuil prédéterminée ;
- la concrétisation de l'au moins une modification (12) lors de la validation.

2. Procédé selon la revendication 1, dans lequel la modification (12) est un agrandissement, un rétrécissement ou une autre modification d'une unité matérielle ou d'un logiciel.

3. Procédé selon la revendication 1 ou la revendication 2, dans lequel l'ensemble de données d'entrée (10) est mis en mémoire dans une unité de mémoire, en particulier sous la forme d'un vecteur de caractéristique.

4. Procédé selon l'une quelconque des revendications précédentes, dans lequel les données associées (14) présentent une description de l'au moins une modification (12) et/ou des autres arrière-plans par rapport à l'au moins une modification, en particulier dans un langage naturel.

5. Procédé selon l'une quelconque des revendications précédentes, dans lequel l'approche basée sur l'apprentissage est sélectionnée à partir du groupe constitué par un réseau neuronal, un apprentissage de renforcement ou un autre algorithme de l'apprentissage machine.

6. Procédé selon la revendication 5, dans lequel le réseau neuronal est un réseau neuronal entraîné.

7. Procédé selon l'une quelconque des revendications précédentes, présentant en outre l'étape intermédiaire après l'étape a., de filtrage de l'ensemble de données d'entrée (10) au moins en partie à l'aide d'au moins un critère de filtrage.

8. Procédé selon la revendication 7, présentant en outre la prise d'une autre mesure lors de la validation ou lors de l'abandon de l'au moins une modification (12).

9. Procédé selon la revendication 8, dans lequel l'autre mesure est une étape de procédé, sélectionnée à partir du groupe constitué par
- l'émission et/ou la transmission d'un message à une unité ; dans lequel le message comprend l'au moins un indicateur (20), la valeur de résultat, l'au moins une modification (12), les données associées (14), d'autres données des ensembles de données d'entrée et/ou de sortie ;
- la concrétisation d'au moins une autre modification, dans lequel l'autre modification est déjà validée.

10. Procédé selon la revendication 9, dans lequel le message prend en compte la valeur de résultat.

11. Dispositif de détermination destiné à la réalisation du procédé selon l'une quelconque des revendications précédentes.

12. Produit de programme informatique avec un programme informatique qui présente des moyens destinés à la réalisation du procédé selon l'une quelconque des revendications 1 à 10, lorsque le programme informatique est mis en oeuvre sur un équipement commandé par programme.
